# EUROPEAN PATENT APPLICATION

(11) **EP 2 515 350 A2**
(43) Date of publication of application: **24.10.2012**
(21) Application number: 12165021.2
(22) Date of filing: 20.04.2012
(51) Int. Cl.: H01L 31/048, H01L 31/18

(54) **Photoelectric Device and Method of Preparing the Same**

(30) Priority: 21.04.2011 KR 20110037299
(71) Applicant: Samsung SDI Co., Ltd., Yongin-si, Gyeonggi-do (KR)
(72) Inventor: Kim, Sung-Su, Gyeonggi-do (KR)
(74) Representative: Walaski, Jan Filip

(57) **Abstract**

A photoelectric device and a method of fabricating the same are disclosed. The photoelectric device may include a first substrate having a first electrode and a first non-slip portion, a second substrate facing the first substrate and having a second electrode and a second non-slip portion and a sealing member. The photoelectric device may further include an electrolyte solution positioned in a spaced formed between the first substrate, the second substrate, and the sealing member. The first substrate or the second substrate may be positioned to contact at least one of a first non-slip portion and a second non-slip portion.

## Description

The present disclosure relates to a photoelectric device and a method of fabricating the same, particularly but not exclusively to a photoelectric device for improving alignment by forming a non-slip portion and a method of fabricating the same.

A solar cell is an energy source with essentially inexhaustible starting material and which is thus environment-friendly. Types of solar cells include silicon solar cells and dye-sensitive solar cells. A silicon solar cell is so expensive to fabricate that it is difficult to commercialize and to improve its efficiency. A dye-sensitive solar cell is, in contrast to the silicon solar cell, a photoelectric chemical solar cell capable of replacing the existing amorphous silicon solar cell because of relatively low manufacturing costs. Further, the dye-sensitive solar cells include dye molecules capable of absorbing visual rays to produce electron-hole pairs and transition metal oxides for delivering the produced electrons. As technologies for the dye-sensitive solar cell develop, records of photoelectric conversion efficiency higher than 10% at standard reporting conditions (SRC) have been reported. Such results have been realized only in a small cell having an active area less than 10 mm by 10 mm. To successfully commercialize the dye-sensitive solar cell, a large scale module must be made. However, since a large scale dye-sensitive solar cell has not been made, position alignment between upper and lower substrates and assembly alignment have not been considered important.

In one aspect, there is provided a photoelectric device for improving assembly alignment between upper and lower substrate by forming a non-slip portion.

In another aspect, a photoelectric device includes, for example, a first substrate including a first electrode and a first non-slip portion, a second substrate facing the first substrate and including a second electrode and a second non-slip portion, a sealing member positioned between the first substrate and the second substrate such that a space is formed between a first side of the sealing member, the first substrate and the second substrate, and a filling electrolyte solution in the space.

In some embodiments, the sealing member contacts at least one of the first non-slip portion and the second non-slip portion. In some embodiments, the photoelectric device further includes, for example, a transparent electrode layer formed on any one of the first substrate and the second substrate; and a counter electrode layer formed opposite the transparent electrode layer. In some embodiments, the first non-slip portion is positioned parallel to a sidewall of the first substrate on which the first electrode is not formed. In some embodiments, the second non-slip portion is positioned parallel to a sidewall of the second substrate on which the second electrode is not formed. In some embodiments, at least one of the first non-slip portion and the second non-slip portion includes a trench formed in the transparent electrode layer or the counter electrode layer. In some embodiments, a portion of the transparent electrode layer or the counter electrode layer is exposed by the trench. In some embodiments, a portion of the first substrate or the second substrate is exposed by the trench. In some embodiments, the trench is formed by laser. In some embodiments, the photoelectric device further includes, for example, a conductive material layer formed in a space between a second side of the sealing member, the first substrate and the second substrate. In some embodiments, the photoelectric device further includes, for example, a connecting terminal electrically connected to the conductive material layer.

In another aspect, a method of fabricating a photoelectric device includes, for example, preparing a first substrate including a first electrode and a first non-slip portion, positioning a second substrate facing the first substrate, the second substrate including a second electrode and a second non-slip portion, disposing a sealing member between the first substrate and the second substrate, and contacting the sealing member with the first substrate and the second substrate to package a filling electrolyte solution in a space formed between a first side of the sealing member, the first substrate and the second substrate.

In some embodiments, the sealing member contacts at least one of the first non-slip portion and the second non-slip portion. In some embodiments, the method further includes, for example, forming a transparent electrode layer on at least one of the first substrate and the second substrate; and forming a counter electrode layer opposite the transparent electrode layer. In some embodiments, the method further includes, for example, forming the first non-slip portion parallel to a sidewall of the first substrate on which the first electrode is not formed. In some embodiments, the method further includes, for example, forming the second non-slip portion parallel to a sidewall of the second substrate on which the second electrode is not formed. In some embodiments, at least one of the first non-slip portion and the second non-slip portion includes a trench formed in the transparent electrode layer. In some embodiments, the transparent electrode layer is exposed by the trench. In some embodiments, at least one of the first substrate and the second substrate is exposed by the trench. In some embodiments, the trench is formed by projecting laser. In some embodiments, the method further includes, for example, forming a conductive material layer on a second side of the sealing member in a space between the first substrate and the second substrate. In some embodiments, the method further includes, for example, forming a connecting terminal electrically connected to the conductive material layer.

In another aspect, a photoelectric device for improving position alignment between respective layers by forming a non-slip portion and the method of fabricating the same is provided.

In addition, since the assembly alignment between upper and lower substrates is improved, processing time may be shortened. This improvement allows for large scale assembly alignment of the photoelectric device and a reduction of misalignment defects, thus improvement in product reliability.

The accompanying drawings, together with the specification, illustrate exemplary embodiments of the present invention, and, together with the description, serve to explain certain principles of the present invention.
FIG. 1 is a sectional view schematically illustrating structure of a unit cell of a photoelectric device according to an embodiment of the present invention.
FIG. 2 is a diagram schematically illustrating pigment connected to an inorganic metal-oxide semiconductor.
FIG. 3A is a plan view schematically illustrating a first substrate of a photoelectric device according to an embodiment of the present invention.
FIG. 3B is a plan view schematically illustrating a second substrate of the photoelectric device according to an embodiment of the present invention.
FIG. 4A is a sectional view schematically illustrating alignment of first and second substrates of a photoelectric device according to a first embodiment of the present invention.
FIG. 4B is a sectional view schematically illustrating an assembly of the first and second substrates of the photoelectric device according to the first embodiment of the present invention.
FIG. 5A is a sectional view schematically illustrating alignment of first and second substrates of a photoelectric device according to a second embodiment of the present invention.
FIG. 5B is a sectional view schematically illustrating an assembly of the first and second substrates of the photoelectric device according to the second embodiment of the present invention.
FIG. 6A is a sectional view schematically illustrating alignment of first and second substrates of a photoelectric device according to a third embodiment of the present invention.
FIG. 6B is a sectional view schematically illustrating an assembly of the first and second substrates of the photoelectric device according to the third embodiment of the present invention.
FIG. 7A is a sectional view schematically illustrating alignment of first and second substrates of a photoelectric device according to a fourth embodiment of the present invention.
FIG. 7B is a sectional view schematically illustrating an assembly of the first and second substrates of the photoelectric device according to the fourth embodiment of the present invention.
FIG. 8 is a sectional view schematically illustrating an assembly of first and second substrates of a photoelectric device according to an embodiment of the present invention.

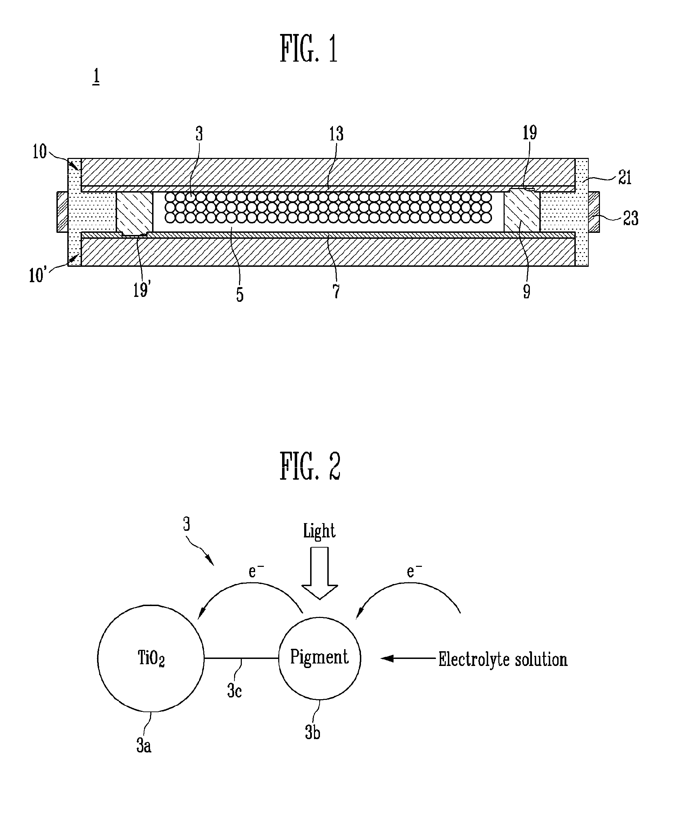

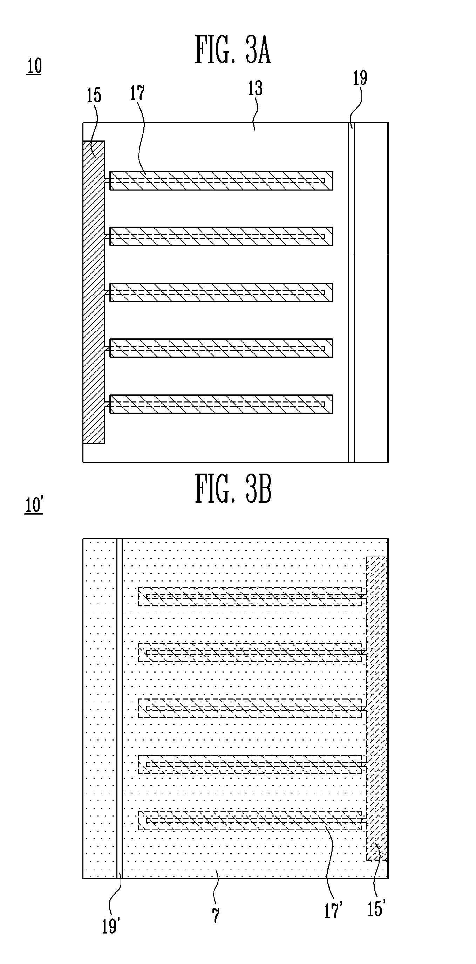

First, referring to FIGs. 1 to 3B, a photoelectric device 1 according to an embodiment of the present invention includes a first substrate 10 having a first electrode 15 and a first non-slip portion 19, a second substrate 10' facing the first substrate 10 and having a second electrode 15' and a second non-slip portion 19', and a sealing member 9 for sealing electrolyte solution 5 between the first substrate 10 and the second substrate 10', wherein the sealing member 9 contacts at least one of the first non-slip portion 19 and the second non-slip-portion 19'. The first substrate 10 may further have a transparent electrode layer 13 formed on the surface thereof and the second substrate 10' may further have a counter-electrode layer 7 formed thereon. The first non-slip portion 19 according to the embodiment may be a trench formed in the transparent electrode layer 13 and the second non-slip portion 19' may be a trench formed in the counter-electrode layer 7. The first and second non-slip portions may alternatively be referred to as alignment portions.

Meanwhile, a conductive material layer 21 may be further formed between the outer side of the sealing member 9, the first substrate 10, and the second substrate 10' and a connecting terminal 23 connected to the conductive material layer 21 may be further formed. Like the above-mentioned structure, the connecting terminal 23 may replace an existing lead wire connected to the outside of the photoelectric device 1 to form a current circuit.

The first non-slip portion 19 is formed parallel to a sidewall of the first substrate 10 where the first electrode 15 is not formed and the second non-slip portion 19' is formed parallel to a sidewall of the second substrate 10' where the second electrode 15' is not formed.

The first substrate 10 and the second substrate 10' are arranged to face each other by a predetermined distance. The first substrate 10 and the second substrate 10' may be formed of any suitable transparent material of low optical absorption from visible light region of the electromagnetic spectrum to near infrared region of solar light, which may be incident on the photoelectric device 1.

Light from outside the photoelectric device may be incident on a first surface of the first substrate 10. On either the first substrate 10 or the second substrate 10', a transparent conductive layer 13 may be formed as a membrane of a transparent conductive oxide (TCO). The transparent conductive oxide may be formed of any suitable conductive material having low photo-absorption from visual ray region to near infrared ray region of external light entering the photoelectric device 1.

To improve photoelectric conversion efficiency, sheet resistance (surface resistance) of the two electrodes 15 and 15' should be as low as possible. However, the second electrode 15' installed on the second substrate 10' facing the first substrate 10 is optional. In some embodiments at least two electrodes are installed on the second substrate 10' and/or the first substrate 10. The second electrode 15' does not need to be transparent. That is, it does not need the low photo-absorption for the external light from visual ray region to the near infrared ray region entering the photoelectric device 1. The first electrode 15 and the second electrode 15' are configured to deliver excited electrons from metal oxide particle 3a to the lead wire. The lead wires may be formed of metal and may be formed on the surfaces of the first substrate 10 and the second substrate 10'.

The first electrode 15 and the second electrode 15' may be formed to prevent the phenomenon in which generated electric current is transformed into heat energy in material having relatively low conductivity such as the transparent conductive layer 13 due to high sheet resistance (higher than about 10Ω/sq) of the transparent conductive layer 13 and in which the photoelectric conversion efficiency is lowered.

Therefore, the first electrode 15 and the second electrode 15' are electrically connected to the transparent conductive layer 13. The first electrode 15 and the second electrode 15' may be formed of high conductivity metal and alloy thereof such as Ag, Ag/Pd, Cu, Au, Ni, Ti, Co, Cr, and/or Al. The first electrode 15 and the second electrode 15' may be formed in any suitable pattern for reducing electric energy loss in the plan direction such as grid, stripe, rectangular and (teeth of) a comb pattern.

Referring to FIG. 1, a photo-electrode layer 3 is a nano-porous membrane formed on the surface of the first electrode 15 by laminating metal oxide particles 31 such as a plurality of TiO2 particles. The photo-electrode layer 3 may be formed of porous material containing a plurality of fine pores to increase the surface of the photo-electrode layer 3. It may be formed and configured to electrically connect a large amount of sensitive pigments 3b to the surfaces of the metal oxide particles 3a so that the photoelectric device 1 may have high photoelectric conversion efficiency. Here, as illustrated in FIG. 2, a connector 3c is disposed between the photo-electrode layer 3 and the metal oxide particle 3a to electrically connect the sensitive pigment 3b so that photo-electrode layer 3 in which an inorganic metal oxide semiconductor is sensitized is obtained.

FIG. 2 schematically shows the sensitive pigment 3b electrically connected to the surface of the metal oxide particle 3a, preferably, the number of sensitive pigments 3b electrically connected to the surface of the metal oxide particle 3a is as many as possible and a plurality of sensitive pigments 3b are coated on the surface of the metal oxide particle 3a as widely as possible.

In general, an inorganic metal oxide has a photoelectric conversion function for light of a predetermined wavelength, but the photoelectric conversion function may be extended to include light from visual rays and near infrared rays by electrically connecting the sensitive pigments 3b to the surface of the metal oxide particle 3a. Any compound in which the photoelectric conversion function is increased by electrically connecting the sensitive pigments 3b may be used as the metal oxide particle 3a. In some embodiments, the metal oxide is titanium oxide (TiO₂) in view of both price and environmental issues. The sensitive pigment 3b may contain a functional group connected to the surface of the metal oxide particle 3a as a connector to rapidly deliver excited electrons of a photoinduced pigment to a conduction band of the inorganic metal oxide.

The counter electrode layer 7 may be configured to serve as a positive electrode of the photoelectric device 1. The counter electrode layer 7 of FIG. 1 is formed of a membrane on the surface of the second substrate 10', on which the second electrode 15' is installed, facing the first substrate 10 on which the first electrode 15 is formed. A metal catalyst layer having conductivity is disposed on the surface (a side of facing the photo-electrode layer 3) of the counter electrode layer 7. Meanwhile, the lead wire is electrically connected to the first electrode 15 in which the photo electrode layer 3 is installed and the counter electrode layer 7. The lead wire from the first electrode 15 and the lead wire from the counter electrode layer 7 are electrically connected to the photoelectric device 1 from the outside so that a circuit may be formed.

Here, the first electrode 15 and the counter electrode layer 7 are spaced apart from each other by a predetermined distance and are electrically isolated and sealed by sealing material 9.

The sealing material 9 may be formed along an outer circumference of the first electrode 15 and the counter electrode layer 7 and may seal a space defined between the first electrode 15 and the counter electrode layer 7. The sealing material 9 may be formed of a resin having high sealing performance and high corrosion resistance such as a film type thermoplastic resin, a photocurable resin, an ionomer resin, a glass frit, and the like.

The electrolyte solution 5 may be placed into the space between the first electrode 15 and the counter electrode layer 7 and may be sealed by the sealing material 9. The electrolyte solution 5 contains, for example, electrolyte, medium, and additives. Here, I3-/I- and Br3-/Br- based redox electrolyte may be used as the electrolyte. A compound exhibiting proper ion conductivity may be used as the medium put into the electrolyte solution 5. Various additives may be added into the electrolyte solution 5 to increase durability and/or electric output of the photoelectric device 1.

In the photo electrode layer 3 containing the metal oxide particle 3a and the sensitive pigment 3b electrically connected to the surface of the metal oxide particle 3a by the connector 3c, as illustrated in FIG. 2, when the sensitive pigment 3b is in an excited state it emits the excited electron when light is in contact with the sensitive pigment 3b electrically connected to the surface of the metal oxide particle 3a. The emitted excited electron may then be delivered to the conduction band of the metal oxide particle 3a through the connector 3c. The excited electron arriving at the metal oxide particle 3a is delivered to other metal oxide particle 3a at the first substrate 10 and then is discharged to the outside the photoelectric device 1 through the lead wire (not shown). Meanwhile, the sensitive pigment 3b short of electrons by giving off the excited electron now receives electrons fed from the counter electrode layer 7 through electrolyte such as I-/I3- within the electrolyte solution 5 and returns to the electrically neutral state.

Meanwhile, the first electrode 15 and the second electrode 15', as described above, are formed of metal such as one or more of Ag, Ag/Pd, Cu, Au, Ni, Ti, Co, Cr, or Al and may be corroded by the electrolyte solution 5 containing iodine (I-/I3-). Therefore, the photoelectric device 1 includes the following protective layers 17 and 17'. The protective layers 17 ad 17' may be configured to prevent and/or restrict corrosion of the first electrode 15 and the second electrode 15' caused by the electrolyte solution 5. The protective layers 17 ad 17' may thus be formed to coat the exposed surfaces of the first electrode 15 and the second electrode 15' to protect the first electrode 15 and the second electrode 15' from corrosion by the electrolyte solution 5. The protective layers 17 and 17' may be formed by coating and performing plastic deformation to glass paste composition with low melting point to the exposed surfaces of the first electrode 15 and the second electrode 15'. The glass paste composition applicable to the protective layers 17 and 17' may be paste composition containing glass frit, binder resin, solvent, and additive.

Hereinafter, a photoelectric device including a non-slip portion according to an embodiment of the present disclosure and a method of fabricating the same will be described with reference to FIGs. 1, 3A to 8.

First, referring to FIGs. 1 to 3B, the photoelectric device 1 according to an embodiment of the present disclosure includes a first substrate 10 having a first electrode 15 and a first non-slip portion 19, a second substrate 10' facing the first substrate 10 and having a second electrode 15' and a second non-slip portion 19', and a sealing member 9 bonding the first substrate 10 and the second substrate 10' and filling electrolyte solution 5 between the first substrate 10 and the second substrate 10', wherein the sealing member 9 is in contact with at least one of the first non-slip portion 19 and the second non-slip portion 19'.

A transparent electrode layer 13 may be further provided on the surface of the first substrate 10 and a counter electrode layer 7 may be further provided on the surface of the second substrate 10'.

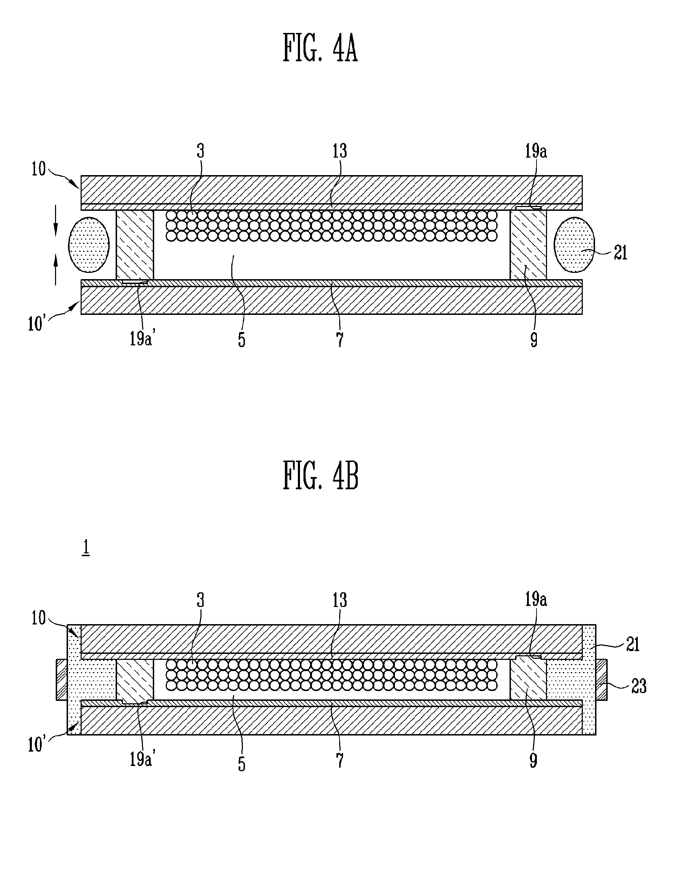

Referring to FIGs. 4A and 4B, a first non-slip portion 19a according to the first embodiment of the present disclosure may be a trench formed in the transparent electrode layer 13 and a second non-slip portion 19a' may be a trench formed in the counter electrode layer 7.

Therefore, the transparent electrode layer 13 and the counter electrode layer 7 are exposed through bottoms of the trenches. Here, the trench may be formed by laser but methods of forming the trench are not limited thereto.

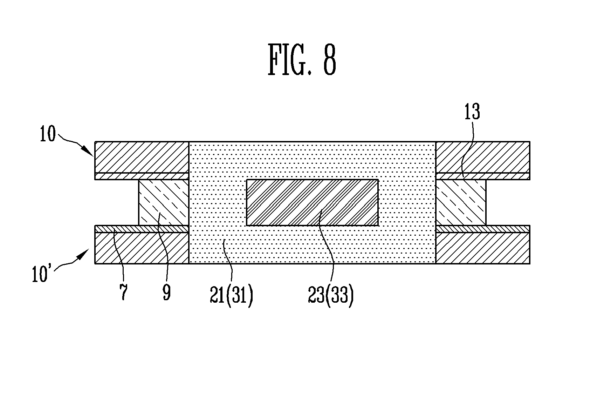

Meanwhile, a conductive material layer 21 may be further formed at the outer side of the sealing member 9 and between the first substrate 10 and the second substrate 10' and form of a desired conductive material layer 21 is completed by pressing in the arrow direction. A connecting terminal 23 connected to the conductive material layer 21 may be further formed. Referring to FIG. 8, the connecting terminal 23 is electrically connected to the outside of the photoelectric device 1 to replace the existing lead wire forming the electrical circuit.

The first non-slip portion 19a is parallel to the sidewall of the first substrate 10 on which the first electrode 15 is not formed and the second non-slip portion 19a' is parallel to the sidewall of the second substrate 10' on which the second electrode 15' is not formed. When the first non-slip portion 19a and the second non-slip portion 19a' are formed, position alignment between respective layers in the photoelectric device 1 and assembly alignment between upper and lower substrates 10 and 10' may be improved.

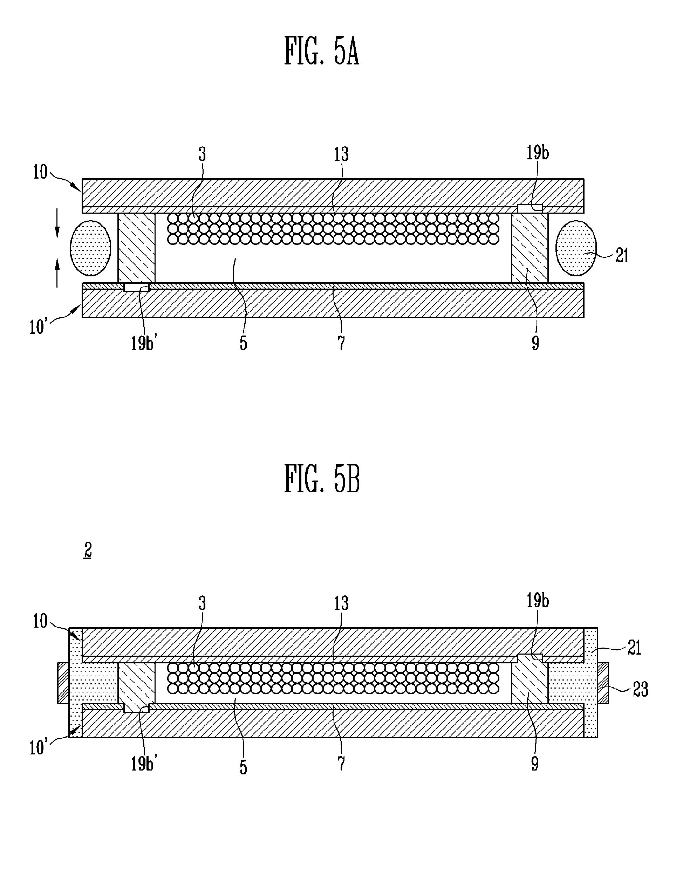

Referring to FIGs. 5A and 5B, a first non-slip portion according to a second embodiment of the present invention may be a trench formed on the first substrate by passing through the transparent electrode layer 13 and a second non-slip portion 19b' may be a trench formed on the second substrate 10' by passing through the counter electrode layer 7. Therefore, the first substrate 10 and the second substrate 10' are exposed through bottoms of the trenches. Here, the trench may be formed by laser but method of forming the trench is not limited thereto.

A conductive material layer 21 may be further formed at the outer side of the sealing member 9 and in a space between the first substrate 10 and the second substrate 10' and form of a desired conductive material layer 21 is completed by pressing in the arrow direction. Next, a connecting terminal 23 connected to the conductive material layer 21 may be further formed. Referring to FIG. 8, the connecting terminal 23 may be electrically connected to the outer side of the photoelectric device 2 to replace the existing lead wire forming an electrical circuit.

The first non-slip portion 19b is parallel to the sidewall of the first substrate 10 on which the first electrode 15 is not formed and the second non-slip portion 19b' is parallel to the sidewall of the second substrate 10' on which the second electrode 15' is not formed.

When the first non-slip portion 19b and the second non-slip portion 19b' are formed, position alignment between respective layers in the photoelectric device 2 and assembly alignment between upper and lower substrates 10 and 10' may be improved.

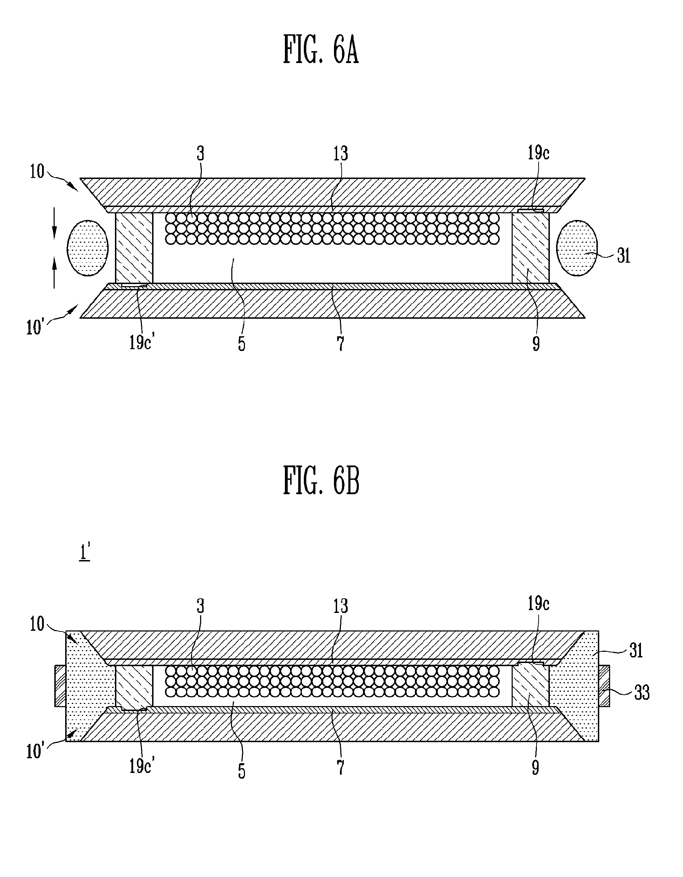

Referring to FIGs. 6a and 6B, a first non-slip portion 19c according to a third embodiment of the present invention may be a trench formed in the transparent electrode layer 13 and a second non-slip portion 19c' may be a trench formed in the counter-electrode layer 7. Therefore, the transparent electrode layer 13 and the counter electrode layer 7 are exposed through bottoms of the trenches. Here, the trench may be formed by laser but methods of forming the trench are not limited thereto.

Meanwhile, surfaces of the first substrate 10 and the second substrate 10' facing the sealing member 9 are cut away. Therefore, more quantity of a conductive material layer 31 may be further formed at the outer side of the sealing member 9 and in a wider area between the first substrate 10 and the second substrate 10' and form of a desired conductive material layer 31 is completed by pressing in the arrow direction. A connecting terminal 33 electrically connected to the conductive material layer 31 may be further formed. Referring to FIG. 8, the connecting terminal 33 is electrically connected to the outside of the photoelectric device 1' to replace the existing lead wire forming the electrical circuit.

The first non-slip portion 19c is parallel to a sidewall of the first substrate 10 where the first electrode 15 is not formed and the second non-slip portion 19c' is parallel to a sidewall of the second substrate 10' where the second electrode 15' is not formed. When the first non-slip portion 19c and the second non-slip portion 19c' are formed, position alignment between respective layers in the photoelectric device 1' and assembly alignment between upper and lower substrates 10 and 10' may be improved.

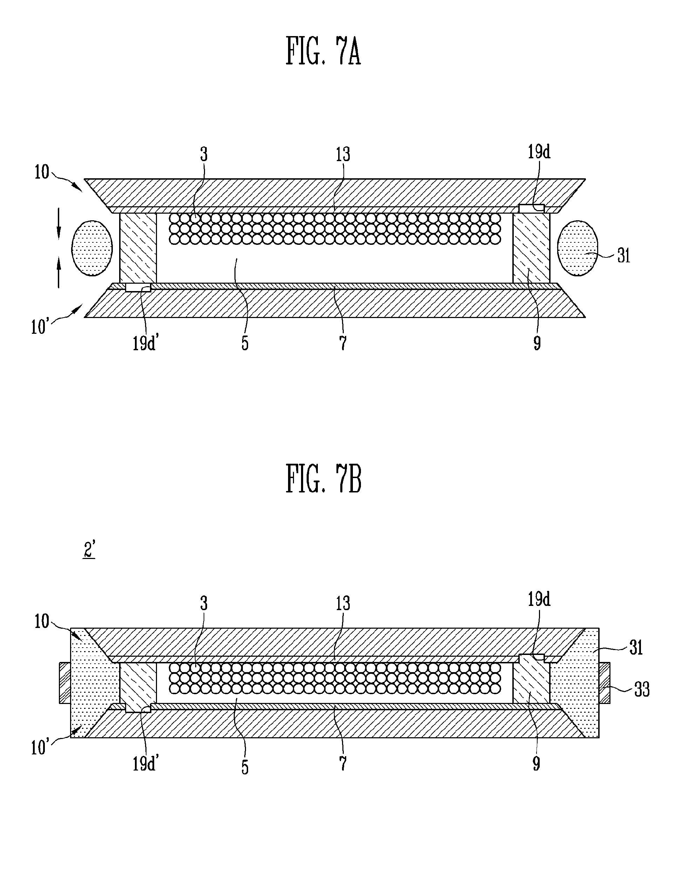

Referring to FIGs. 7A and 7B, a first non-slip portion 19d according to a fourth embodiment of the present invention may be a trench formed on the first substrate 10 by passing through the transparent electrode layer 13 and a second non-slip portion 19d' may be a trench formed on the second substrate 10' by passing through the counter-electrode layer 7. Therefore, the first substrate 10 and the second substrate 10' are exposed through bottoms of the trenches. Here, the trench may be formed by laser but methods of forming the trench are not limited thereto.

Meanwhile, surfaces of the first substrate 10 and the second substrate 10' facing the sealing member 9 are cut away. Therefore, a greater quantity of a conductive material layer 31 may be further formed at the outer side of the sealing member 9 and in a wider area between the first substrate 10 and the second substrate 10' and form of a desired conductive material layer 31 is completed by pressing in the arrow direction. A connecting terminal 33 electrically connected to the conductive material layer 31 may be further formed. Referring to FIG. 8, the connecting terminal 33 is electrically connected to the outside of the photoelectric device 2' to replace the existing lead wire forming the electrical circuit. The first non-slip portion 19d is parallel to a sidewall of the first substrate 10 where the first electrode 15 is not formed and the second non-slip portion 19d' is parallel to a sidewall of the second substrate 10' where the second electrode 15' is not formed.

When the first non-slip portion 19d and the second non-slip portion 19d' are formed, position alignment between respective layers in the photoelectric device 2' and assembly alignment between upper and lower substrates 10 and 10' may be improved.

According to the present disclosure, a photoelectric device for improving position alignment between respective layers by forming a non-slip portion and a method of fabricating the same may be provided.

In addition, since assembly alignment between upper and lower substrates is improved, processing time may be shortened. Improved assembly alignment allows for large scale manufacturing of photoelectric devices. Further, the methods described herein may reduce misalignment product defects, such that product reliability is enhanced.

The present invention has been described in connection with certain exemplary embodiments, it is to be understood that the invention is not limited to the disclosed embodiments, but, on the contrary, is intended to cover various modifications and equivalent arrangements included within the scope of the appended claims, and equivalents thereof.

## Claims

1. A photoelectric device, comprising:
a first substrate including a first electrode and a first non-slip portion;
a second substrate facing the first substrate and including a second electrode and a second non-slip portion;
a sealing member positioned between the first substrate and the second substrate such that a space is formed between a first side of the sealing member, the first substrate and the second substrate; and
electrolyte in the space,
wherein the sealing member contacts at least one of the first non-slip portion and the second non-slip portion.

2. The photoelectric device of claim 1, further comprising:
a transparent electrode layer formed on the first substrate or the second substrate; and
a counter electrode layer formed opposite the transparent electrode layer.

3. The photoelectric device of claim 1 or 2, wherein the first non-slip portion is positioned parallel to a sidewall of the first substrate on which the first electrode is not formed.

4. The photoelectric device of any one of the preceding claims, wherein the second non-slip portion is positioned parallel to a sidewall of the second substrate on which the second electrode is not formed.

5. The photoelectric device of any one of the preceding claims when dependent on claim 2, wherein at least one of the first non-slip portion and the second non-slip portion comprises a trench formed in the transparent electrode layer or the counter electrode layer.

6. The photoelectric device of claim 5, wherein a portion of the transparent electrode layer or the counter electrode layer is exposed by the trench.

7. The photoelectric device of claim 5, wherein a portion of the first substrate or the second substrate is exposed by the trench.

8. The photoelectric device of any one of the preceding claims further comprising a conductive material layer formed in a space between a second side of the sealing member, the first substrate and the second substrate.

9. The photoelectric device of claim 8, further comprising a connecting terminal electrically connected to the conductive material layer.

10. A method of fabricating a photoelectric device, comprising:
preparing a first substrate comprising a first electrode and a first non-slip portion;
positioning a second substrate facing the first substrate, wherein the second substrate comprises a second electrode and a second non-slip portion;
disposing a sealing member between the first substrate and the second substrate; and
contacting the sealing member with the first substrate and the second substrate to seal an electrolyte in a space formed between a first side of the sealing member, the first substrate and the second substrate,
wherein the sealing member contacts at least one of the first non-slip portion and the second non-slip portion.

11. The method of claim 10, further comprising forming a transparent electrode layer on at least one of the first substrate and the second substrate; and forming a counter electrode layer opposite the transparent electrode layer.

12. The method of claim 10 or 11, further comprising forming the first non-slip portion parallel to a sidewall of the first substrate on which the first electrode is not formed.

13. The method of claim 10, 11 or 12, further comprising forming the second non-slip portion parallel to a sidewall of the second substrate on which the second electrode is not formed.

14. The method of any one of claims 11 to 13, when dependent on claim 11, wherein at least one of the first non-slip portion and the second non-slip portion comprises a trench formed in the transparent electrode layer.

15. The method of claim 14, wherein the trench is formed by laser.
